(19) Europäisches Patentamt
European Patent Office
Office européen des brevets

(11) **EP 4 700 409 A1**

(12) **EUROPEAN PATENT APPLICATION**
published in accordance with Art. 153(4) EPC

(43) Date of publication:
**25.02.2026 Bulletin 2026/09**

(21) Application number: **24792612.4**

(22) Date of filing: **12.04.2024**

(51) International Patent Classification (IPC):
*G01R 31/389* (2019.01)     *G01R 27/08* (2006.01)
*G01R 31/382* (2019.01)     *G01R 31/385* (2019.01)
*G01R 31/392* (2019.01)     *H01M 10/48* (2006.01)
*H02J 7/00* (2026.01)

(52) Cooperative Patent Classification (CPC):
Y02E 60/10

(86) International application number:
**PCT/JP2024/014850**

(87) International publication number:
**WO 2024/219337 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.04.2023 JP 2023068860**

(71) Applicant: **Vehicle Energy Japan Inc.**
**Hitachinaka-shi, Ibaraki 312-8505 (JP)**

(72) Inventors:
• **SAKABE, Kei**
**Hitachinaka-shi, Ibaraki 312-8505 (JP)**
• **OGINO, Naoaki**
**Hitachinaka-shi, Ibaraki 312-8505 (JP)**

(74) Representative: **MERH-IP Matias Erny Reichl Hoffmann**
**Patentanwälte PartG mbB**
**Paul-Heyse-Straße 29**
**80336 München (DE)**

(54) **BATTERY CONTROL DEVICE AND VEHICLE CONTROL DEVICE**

(57)     A battery control device (100) includes a computing device (battery controller 101) that computes an internal resistance value (DCR) of a battery (300). The battery controller (101) computes a current differential value ($\Delta I$) on the basis of a first current value (I1) measured at a first clock time (t1) serving as a target measurement clock time and a second current value (I2) measured at a second clock time (t2) serving as a target measurement clock time at which a predetermined time has elapsed from the first clock time (t1). The battery controller (101) computes a voltage differential value ($\Delta V$) on the basis of a first voltage value (V1) measured at a predetermined clock time serving as a target measurement clock time that is later than the first clock time (t1) and a second voltage value (V2) measured at a third clock time (t3) serving as a target measurement clock time at which a predetermined time has elapsed from the second clock time (t2) and that is later than the predetermined clock time. The battery controller (101) computes the internal resistance value (DCR) of the battery (300) on the basis of the current differential value ($\Delta I$) and the voltage differential value ($\Delta V$).

[FIG. 6]

**Description**

Technical Field

The present invention relates to a battery control device and a vehicle control device.

Background Art

A technique for computing an internal resistance value of a battery in order to know the state of deterioration of the battery or the like has been known from the past (see Patent Document 1).

Prior Art Document

Patent Document

Patent Document 1: JP-2021-092403-A

Summary of the Invention

Problem to be Solved by the Invention

In the control of a battery and a vehicle, it is required to improve the reliability of a computed internal resistance value of a battery. The current value and the voltage value of the battery are measured to compute the internal resistance value of the battery. Due to a measurement error of the battery, there is a case where the current value and the voltage value of the battery are not measured at the same time even if the time difference is small, and the voltage value of the battery is measured relatively earlier than the current value. In this case, there is a possibility that the current value and the voltage value of the battery relatively largely change in a short time from the measurement of the voltage value of the battery to the measurement of the current value.

Means for Solving the Problem

A battery control device according to one aspect of the present invention includes a computing device that computes an internal resistance value of a battery. The computing device computes a current differential value on the basis of a first current value measured at a first clock time serving as a target measurement clock time and a second current value measured at a second clock time serving as a target measurement clock time at which a predetermined time has elapsed from the first clock time. The computing device computes a voltage differential value on the basis of a first voltage value measured at a predetermined clock time serving as a target measurement clock time that is later than the first clock time and a second voltage value measured at a third clock time serving as a target measurement clock time that is later than the predetermined clock time and at which a predetermined time has elapsed from the second clock time. The computing device computes the internal resistance value of the battery on the basis of the current differential value and the voltage differential value.

A vehicle control device according to one aspect of the present invention includes the battery control device. The vehicle control device controls a vehicle having the battery and electric equipment operated by electric power of the battery.

Advantages of the Invention

According to the present invention, it is possible to improve the reliability of a computed internal resistance value of a battery.

Brief Description of the Drawings

FIG. 1 is a diagram for depicting a schematic configuration of a vehicle 1 mounted with a battery control device 100 of an embodiment.
FIG. 2 is a diagram for depicting an example of a hardware configuration of a vehicle control system mounted in the vehicle 1.

FIG. 3 is a functional block diagram of the battery control device 100.

FIG. 4 relates to an ideal (state of no error) measurement timing, is a graph for depicting time changes of a current value I measured by a current sensor 102 and time changes of a voltage value V measured by a voltage sensor 103, and depicts the deviation width of the measurement timing of the voltage value V.

FIG. 5 relates to a measurement timing of a comparison example, is a graph for depicting time changes of the current value I measured by the current sensor 102 and time changes of the voltage value V measured by the voltage sensor 103, and depicts an example in which an internal resistance value is underestimated.

FIG. 6 relates to a measurement timing of the present embodiment, is a graph for depicting time changes of the current value I measured by the current sensor 102 and time changes of the voltage value V measured by the voltage sensor 103, and depicts the measurement timings of the current value I and the voltage value V.

FIG. 7 is a flowchart for depicting an example of a flow of processing executed by a battery controller 101.

FIG. 8 is a table for depicting a target measurement clock time, a time from a predetermined clock time to each target measurement clock time, and actual measurement values (current values and voltage values).

FIG. 9 is a table for depicting a target measurement clock time, a time from a predetermined clock time to each target measurement clock time, and actual measurement values (current values and voltage values), and depicts an example in which the measurement cycle of the current value is 1/2 of the measurement cycle of the voltage value.

Modes for Carrying Out the Invention

(Configuration of embodiment)

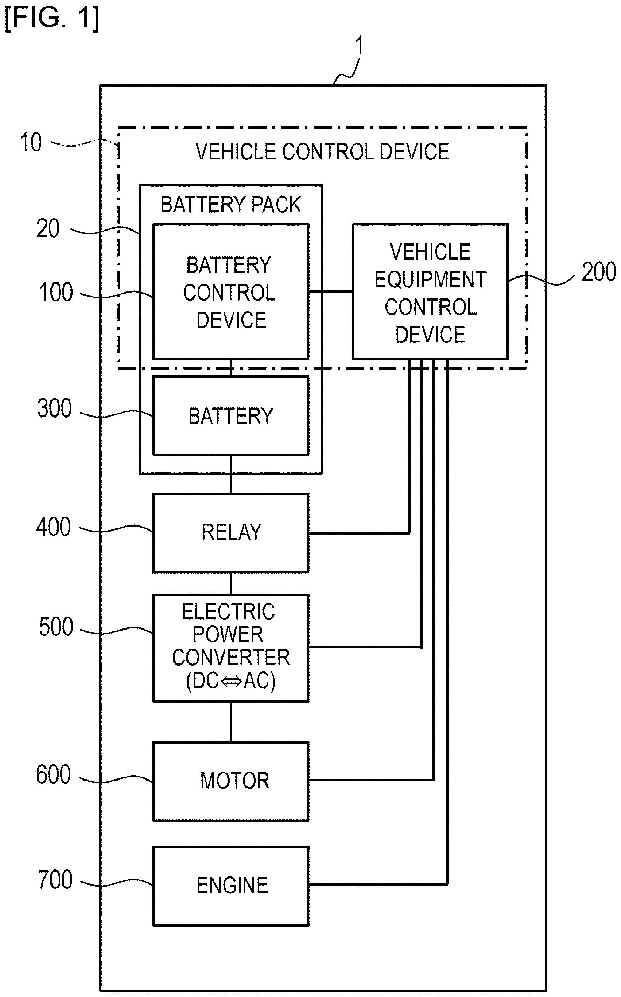

Configurations of a battery control device 100 and a vehicle control device 10 including the battery control device 100 of an embodiment will be described with reference to FIG. 1.

FIG. 1 is a diagram for depicting a schematic configuration of a vehicle 1 mounted with the battery control device 100 of the embodiment.

As depicted in FIG. 1, the vehicle 1 is configured with, for example, a hybrid electric vehicle. The hybrid electric vehicle is, for example, an HEV (Hybrid Electric Vehicle) or a PHEV (Plug-in Hybrid Electric Vehicle). The hybrid electric vehicle includes a strong hybrid electric vehicle having an output voltage of, for example, several hundred volts and a mild hybrid electric vehicle having an output voltage of, for example, 48 volts. The vehicle 1 may be configured with an EV (Electric Vehicle).

In the case where the vehicle 1 is a hybrid electric vehicle, the vehicle 1 includes a motor 600 as electric equipment used for travelling driving the vehicle 1 and an engine 700 as an internal combustion engine. Power generated by the motor 600 and the engine 700 is transmitted to wheels through a power transmission mechanism. In the case where the vehicle 1 is an EV (Electric Vehicle), the engine 700 is not provided in the vehicle 1. Therefore, the power generated by the motor 600 is transmitted to the wheels through the power transmission mechanism. The motor 600 is operated by electric power from a battery pack 20 to generate power.

The vehicle 1 includes the vehicle control device 10, a battery 300, a relay 400, an electric power converter 500, the motor 600, and the engine 700. The vehicle control device 10 includes the battery control device 100 and a vehicle equipment control device 200. The battery pack 20 includes the battery control device 100 and the battery 300. Details of the vehicle control device 10 will be described later.

The battery 300 is configured with, for example, an assembled battery. The assembled battery includes a plurality of single cells. A plurality of secondary batteries are connected in series, in parallel, or in series and in parallel by bus bars. The single cell is, for example, a secondary battery. The secondary battery is, for example, a lithium-ion battery. It should be noted that the secondary battery may be configured with a device having an electric power storage function such as a nickel-hydrogen battery, an all-solid-state battery, a lead battery, or an electric double-layer capacitor. In addition, the battery 300 is not limited to a battery configured with a plurality of secondary batteries, but may be configured with one secondary battery. The battery 300 is not limited to a battery configured with a plurality of secondary batteries, but may be configured with a primary battery. The electric power of the battery 300 is supplied to the motor 600 through the relay 400 and the electric power converter 500.

The relay 400 is electrically connected to the battery 300 and the electric power converter 500. The relay 400 energizes the motor 600 from the battery 300 or interrupts the energization from the battery 300 to the motor 600.

The electric power converter 500 transforms the voltage while converting electric power between a direct current (DC) and an alternating current (AC). The electric power converter 500 is electrically connected to the relay 400 and the motor 600. The electric power converter 500 includes an inverter circuit and a converter circuit.

The motor 600 performs a power running operation for generating a driving force and a regenerative operation for recovering energy, according to the travelling state of the vehicle 1. In the power running operation of the motor 600, the electric power converter 500 transforms the voltage while converting the electric power of the battery 300 from a direct current to an alternating current, and supplies it to the motor 600. Accordingly, power is generated by the motor 600, and the vehicle 1 travels. In addition, where the vehicle 1 travels by the power of the engine 700, the vehicle 1 is accelerated by the power of the motor 600. In the regenerative operation of the motor 600, the electric power converter 500 transforms the voltage while converting the electric power generated by the motor 600 from an alternating current to a direct current, and supplies it to the battery 300. Accordingly, the battery 300 is charged.

The engine 700 is an example of an internal combustion engine. The engine 700 is used for driving the vehicle 1. The engine 700 is used as power for wheels of the vehicle 1. Where the vehicle 1 is an EV (Electric Vehicle), the engine 700 is unnecessary.

Each of the battery control device 100 and the vehicle equipment control device 200 configuring the vehicle control device 10 is configured with an ECU (Electronic Control Unit). It should be noted that the vehicle control device 10 may be configured with one ECU including the function of the battery control device 100 and the function of the vehicle equipment control device 200. The battery control device 100 is also referred to as, for example, a battery management system (BMS).

The vehicle equipment control device 200 controls driving equipment of the vehicle 1 on the basis of battery information or the like output from the battery control device 100. The driving equipment of the vehicle 1 includes the relay 400, the electric power converter 500, the motor 600, and the engine 700.

(Hardware configuration of vehicle control system)

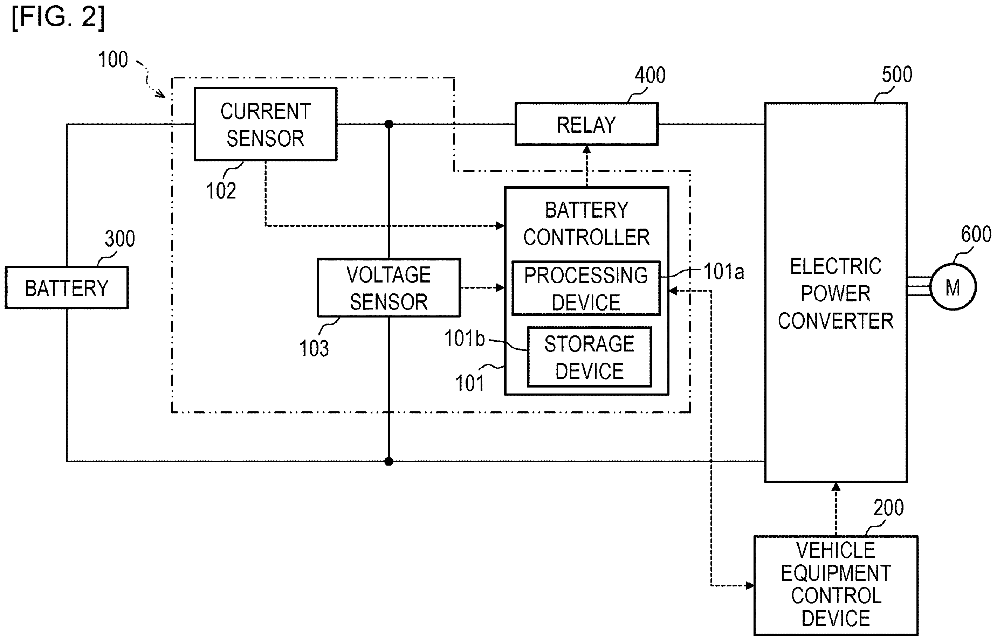

FIG. 2 is a diagram for depicting an example of a hardware configuration of a vehicle control system mounted in the vehicle 1. As depicted in FIG. 2, the battery control device 100 includes a battery controller 101, a current sensor 102 connected in series to the battery 300, and a voltage sensor 103 connected in parallel to the battery 300. The current sensor 102 measures a value (hereinafter, also referred to as a current value) I of the charge/discharge current of the battery 300. The voltage sensor 103 measures a value (hereinafter, also referred to as a voltage value) V of the voltage of the battery 300. The measurement results of the current sensor 102 and the voltage sensor 103 are input to the battery controller 101.

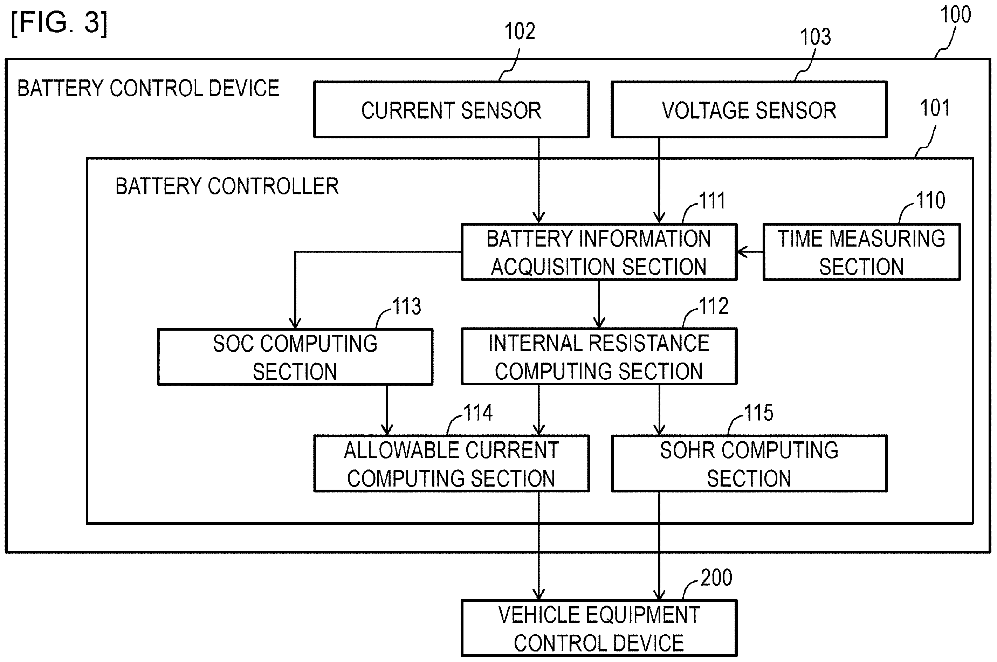

The battery controller 101 is configured with a computer including a processing device 101a, a storage device 101b, an input interface, an output interface, and other peripheral circuits. These pieces of hardware operate software in cooperation to realize a plurality of functions (see FIG. 3) to be described later. It should be noted that the battery controller 101 may be configured with one computer or a plurality of computers.

The processing device 101a includes, for example, a CPU (Central Processing Unit), an MPU (Micro Processing Unit), a DSP (Digital Signal Processor), and the like. The storage device 101b includes a nonvolatile memory such as a ROM (Read Only Memory), a flash memory, and a hard disk drive. In addition, the storage device 101b includes a volatile memory called a RAM (Random Access Memory).

In the nonvolatile memory of the storage device 101b, programs capable of executing various computations are stored. That is, the nonvolatile memory is a storage medium (storage device) capable of reading a program that realizes the function of the present embodiment. The volatile memory is a storage medium (storage device) for temporarily storing a computation result computed by the processing device 101a and a signal input from an input interface. The processing device 101a is a device for developing a program stored in the nonvolatile memory into the volatile memory and executing computations, and performs predetermined computation processing on data taken in from an input interface and the storage device 101b in accordance with the program.

(Function of battery control device 100)

FIG. 3 is a functional block diagram of the battery control device 100. As depicted in FIG. 3, the battery controller 101 has a time measuring section 110, a battery information acquisition section 111, an internal resistance computing section 112, an SOC computing section 113, an allowable current computing section 114, and an SOHR computing section 115.

The time measuring section 110 measures time. The battery information acquisition section 111 acquires battery information that is information related to the state of the battery 300 at predetermined time intervals on the basis of the time measured by the time measuring section 110. The battery information includes measurement results of the current sensor 102 and the voltage sensor 103.

The internal resistance computing section 112 computes an internal resistance value R of the battery 300 on the basis of the voltage value V and the current value I of the battery 300 acquired by the battery information acquisition section 111. Details of the computation method for the internal resistance value R will be described later.

The SOC computing section 113 computes a charge rate SOC (State of Charge) of the battery 300. The SOC computing section 113 computes the charge rate SOC by, for example, integrating the current value I acquired by the battery information acquisition section 111. It should be noted that the SOC computing section 113 may compute the charge rate SOC from an open voltage OCV when no charge/discharge is performed.

The allowable current computing section 114 computes an allowable current value on the basis of the internal resistance value R computed by the internal resistance computing section 112 and the charge rate SOC computed by the SOC computing section 113. The computation result of the allowable current computing section 114 is input to the vehicle equipment control device 200.

The SOHR computing section 115 computes a resistance increase rate SOHR on the basis of the internal resistance value R computed by the internal resistance computing section 112 and a reference resistance value Ri that is the internal resistance value stored in the storage device 101b when the battery is new. The resistance increase rate SOHR is computed by dividing the internal resistance value R by the reference resistance value Ri (SOHR = R/Ri). The computation result of the SOHR computing section 115 is input to the vehicle equipment control device 200. The resistance increase rate SOHR is one of indices indicating the deterioration state of the battery 300.

The vehicle equipment control device 200 controls each part of the vehicle 1 on the basis of the battery information acquired from the battery control device 100. For example, the vehicle equipment control device 200 controls electric equipment (the motor 600 and the like) on the basis of the allowable current and the resistance increase rate SOHR acquired from the battery control device 100.

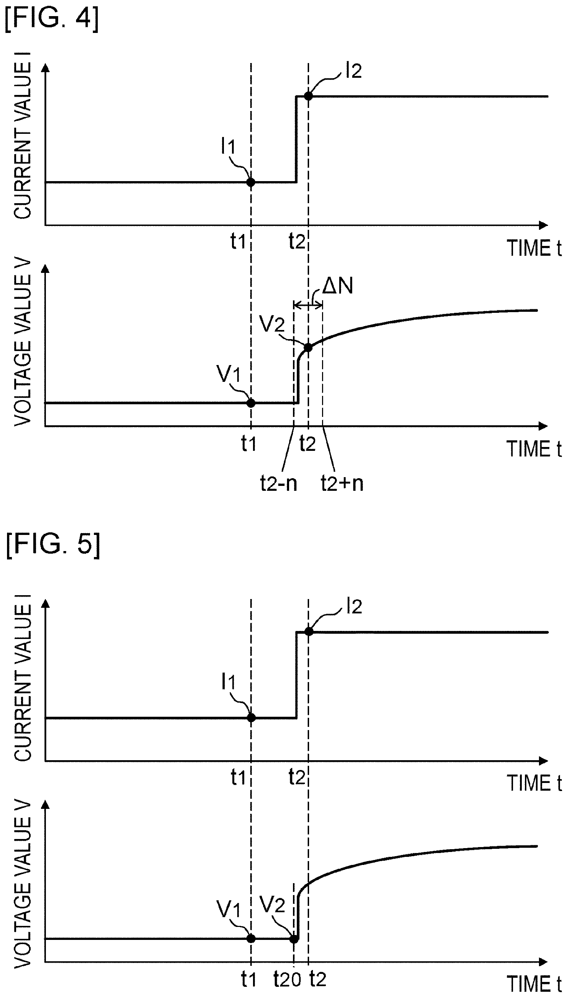

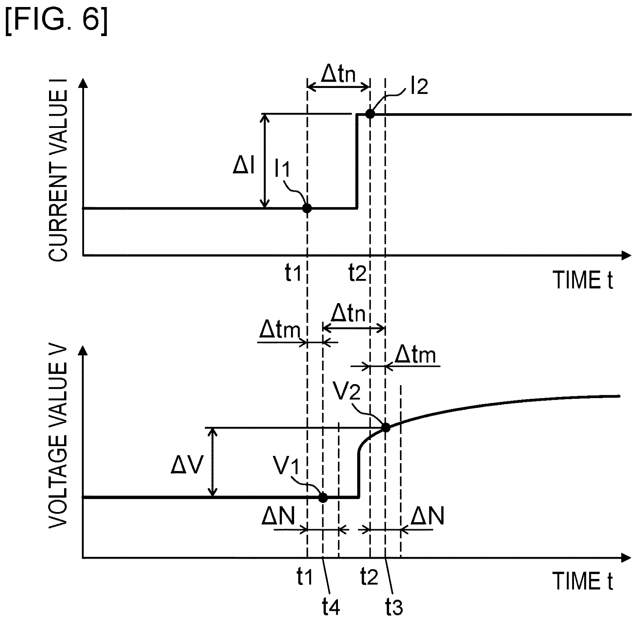

FIG. 4 to FIG. 6 are graphs for indicating time changes of the current value I measured by the current sensor 102 and time changes of the voltage value V measured by the voltage sensor 103. FIG. 4 relates to an ideal (a state of no error) measurement timing. FIG. 5 relates to a measurement timing of a comparison example. FIG. 6 relates to a measurement timing of the present embodiment.

The internal resistance computing section 112 computes the internal resistance value R (DC resistance value DCR) according to the following Equation (1) when the current value I changes or the like case.

$$R = (V2 - V1)/(I2 - I1) \qquad ...(1)$$

Here, a first current value I1 is a current value before the current value I changes. A first voltage value V1 is a voltage value before the current value I changes. A second current value I2 is a current value after the current value I has changed. A second voltage value V2 is a voltage value after the current value I has changed.

As the ideal (the state of no error) measurement timing depicted in FIG. 4, the internal resistance value R is appropriately computed if the current value I and the voltage value V are measured at the same timing before and after a large current change. However, the current value I and the voltage value V are measured by different circuits (see FIG. 2). Therefore, even if the target measurement clock time of the current value I and the target measurement clock time of the voltage value V are set to the same time, a slight deviation occurs between the actual measurement clock time of the current value I and the actual measurement clock time of the voltage value V. This deviation causes occurrence of a large error in the estimation of the internal resistance value R.

The deviation of the actual measurement clock time of the second voltage value V2 from the actual measurement clock time of the second current value I2 occurs within the range of a deviation width ΔN (= 2×n) between clock time (t2 - n) and clock time (t2 + n). The deviation width ΔN of the measurement timing is the maximum value of variations in the measurement timing of the voltage value V that may occur in design. The maximum value of the variations in the measurement timing is determined by a plurality of factors such as a synchronization deviation between the processing device 101a and the voltage sensor 103, a variation in the amount of communication delay, and a variation in clock accuracy. The required specification of the deviation width ΔN of the measurement timing is determined from a computation error or the like allowable for the internal resistance value (DC resistance value) of the battery 300. The plurality of factors are designed to satisfy the required specification of the deviation width ΔN. The above-described "n" is the maximum deviation amount (the maximum deviation amount on the negative side and the maximum deviation amount on the positive side) of the actual measurement clock time of the second voltage value V2 on the basis of the actual measurement clock time of the second current value I2. The negative side is the side where the clock time becomes relatively early. The positive side is the side where the clock time is relatively late.

As the measurement timing of the comparison example depicted in FIG. 5, for example, in the case where the voltage value V measured at the timing of clock time t20 before the current value I changes is used as the second voltage value V2 in the computation of Equation (1), the following may occur. That is, the computed internal resistance value R may be a value less than the actual value, that is, a value with low reliability. As a result, the reliability of the computation result of the computation processing using the internal resistance value R, such as the computation processing of the resistance increase rate SOHR, may be lowered.

The deviation between the actual measurement clock time of the current value I and the actual measurement clock time of the voltage value V occurs in design, and it is difficult to completely prevent it. Therefore, in the present embodiment, the measurement timings of the current value I and the voltage value V are intentionally deviated from each other in consideration of the deviation width ΔN. Specifically, the measurement timing of the voltage value V is controlled such that the actual measurement clock time of the second voltage value V2 used for computing the internal resistance value R is later than the actual measurement clock time of the second current value I2 measured after a current change.

The measurement timings of the current value I and the voltage value V in the present embodiment will be described with reference to FIG. 6. By delaying the target value of the measurement timing of the voltage value from the target value of the measurement timing of the current value by a predetermined time, the internal resistance value R is computed by the voltage value V measured after the change of the current value I without depending on the magnitude of the deviation between the measurement timing of the current value I and the measurement timing of the voltage value V. Accordingly, it is possible to prevent the computed internal resistance value R from becoming a small value. That is, it is possible to reduce the influence of the internal resistance value R on the computation caused by the deviation of the measurement timing. Thus, according to the present embodiment, the robustness of the computation of the internal resistance value R is improved against the error factor such as the deviation between the measurement timings of the current value I and the voltage value V, and the reliability and accuracy of the computed internal resistance value R are improved.

In FIG. 6, a first clock time t1 is the target measurement clock time of a first current value I1, and a second clock time t2 is the target measurement clock time of a second current value I2. FIG. 6 depicts an example in which the target measurement clock time of the current value I coincides with the actual measurement clock time of the current value I for convenience of explanation. In addition, in FIG. 6, a fourth clock time t4 is the target measurement clock time of a first voltage value V1, and a third clock time t3 is the target measurement clock time of a second voltage value V2. In FIG. 6, the time from the target measurement clock time of the current value I to the target measurement clock time of the voltage value V is illustrated in an exaggerated manner. In practice, the time from the target measurement clock time of the current value I to the target measurement clock time of the voltage value V is, for example, approximately 1/100 of a predetermined time $\Delta tn$ that is the measurement cycle of the current value I and the voltage value V.

As depicted in FIG. 6, in the present embodiment, the current value I is periodically and repeatedly measured at the predetermined time $\Delta tn$ that is the measurement cycle. The voltage value V is periodically and repeatedly measured at the predetermined time $\Delta tn$. The predetermined time $\Delta tn$ is, for example, approximately several tens to several hundreds [ms (milliseconds)]. The predetermined time $\Delta tn$ is determined in advance on the basis of the control specifications of the vehicle 1, the specifications of the DC resistance value DCR, the charge rate SOC, a discharge performance SOF, and the like, the specifications of monitoring and protection of the battery 300, and the like.

In the present embodiment, the target measurement clock time of the voltage value V is set to a clock time that is a predetermined time $\Delta tm$ (fixed value) later than the target measurement clock time of the current value I regardless of the change in the current value I. For example, the third clock time t3 that is the target measurement clock time of the second voltage value V2 after the current change is set to a clock time that is the predetermined time $\Delta tm$ later than the second clock time t2. In addition, the fourth clock time t4 that is the target measurement clock time of the first voltage value V1 before the current change is set to a clock time that is the predetermined time $\Delta tm$ later than the first clock time t1. The predetermined time $\Delta tm$ is, for example, approximately 0.5 to several [ms]. It is preferable that the predetermined time $\Delta tm$ is set to be larger than a maximum deviation amount n that is half of the deviation width $\Delta N$ of the actual measurement clock time of the second voltage value V2 from the actual measurement clock time of the second current value I2.

As described above, the predetermined time $\Delta tn$ of the current value I and the predetermined time $\Delta tn$ of the voltage value V are set to the same value. Therefore, the time $\Delta tm$ from the first clock time t1 to the fourth clock time t4 is equal to the time $\Delta tm$ from the second clock time t2 to the third clock time t3.

The predetermined time $\Delta tm$ is determined as follows in the case where the actual measurement clock time of the second current value I2 deviates from the target measurement clock time to the positive side at the maximum and the actual measurement clock time of the second voltage value V2 deviates from the target measurement clock time to the negative side at the maximum. That is, the predetermined time $\Delta tm$ is determined such that the actual measurement clock time of the second voltage value V2 is later than the actual measurement clock time of the second current value I2. In other words, the predetermined time $\Delta tm$ is determined to be larger than the maximum value of the time from the actual measurement clock time of the second current value I2 to the actual measurement clock time of the second voltage value V2 in the case where the target measurement clock times of the second current value I2 and the second voltage value V2 are the same. It should be noted that if the predetermined time $\Delta tm$ becomes too large, the reliability of the computed internal resistance value R decreases. Therefore, the predetermined time $\Delta tm$ is at least shorter than the time from the fourth clock time t4 to the second clock time t2. It should be noted that the predetermined time $\Delta tm$ is preferably as short as possible while satisfying the above conditions.

(Example of flow of processing executed by battery controller 101)

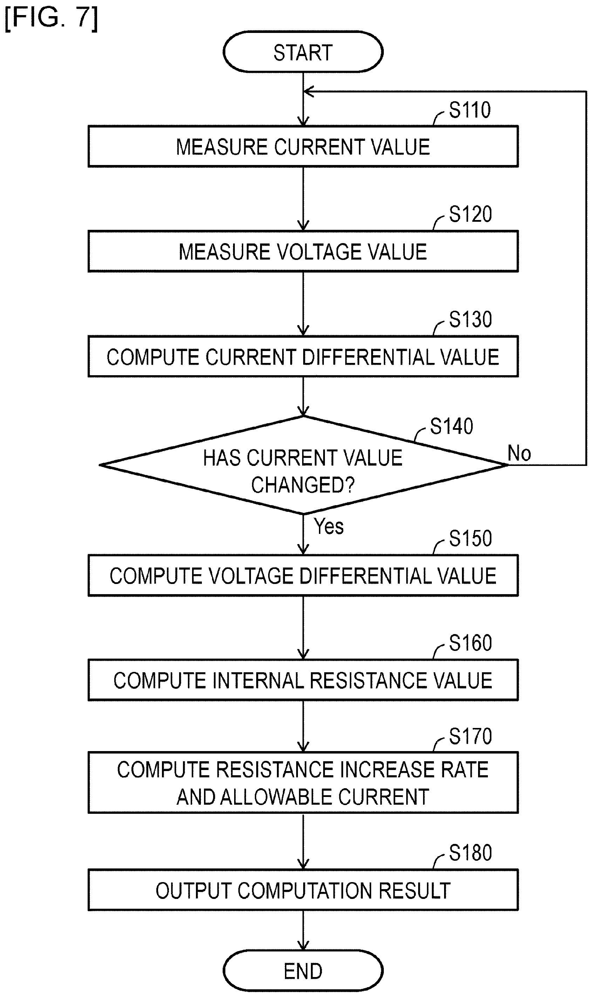

FIG. 7 is a flowchart for depicting an example of a flow of processing executed by a battery controller 101. The processing depicted in the flowchart of FIG. 7 is started by, for example, turning on an ignition switch (not illustrated) of the vehicle 1 and is repeatedly executed.

As depicted in FIG. 7, in Step S110, the battery controller 101 acquires a detection result of the current sensor 102. In Step S120 that follows, the battery controller 101 acquires a detection result of the voltage sensor 103 after the predetermined time Δtm has elapsed from Step S110. In other words, the battery controller 101 acquires the detection result of the voltage sensor 103 at the clock time at which the predetermined time Δtm has elapsed from the target measurement clock time of the current value I, as the target measurement clock time.

In Step S130 that follows, the battery controller 101 computes a current differential value ΔI that is the difference between the present value of the current value acquired in Step S110 and the previous value.

In Step S140 that follows, the battery controller 101 determines whether the current value I has changed on the basis of the current differential value ΔI computed in Step S130. When the absolute value |ΔI| of the current differential value ΔI is equal to or larger than a threshold value ΔI0, the battery controller 101 determines that the current value I has changed. In this case, the processing proceeds to Step S150. When the absolute value |ΔI| of the current differential value ΔI is smaller than the threshold value ΔI0, the battery controller 101 determines that the current value I has not changed. In this case, the processing returns to Step S110.

In Step S150, the battery controller 101 computes a voltage differential value ΔIV that is the difference between the present value of the voltage value acquired in Step S120 and the previous value.

In Step S160 that follows, the battery controller 101 computes the internal resistance value R on the basis of the current differential value ΔI computed in Step S130 and the voltage differential value ΔV computed in Step S150 ($R = \Delta V/\Delta I = (V2 - V1)/(I2 - I1)$).

In Step S170 that follows, the battery controller 101 computes the resistance increase rate SOHR and the allowable current by using the internal resistance value R computed in Step S160, the charge rate SOC computed by processing not illustrated, and the like.

In the Step S180 that follows, the battery controller 101 outputs the computation results in the Step 160 and Step 170 to the vehicle equipment control device 200.

(Operation example of battery controller 101)

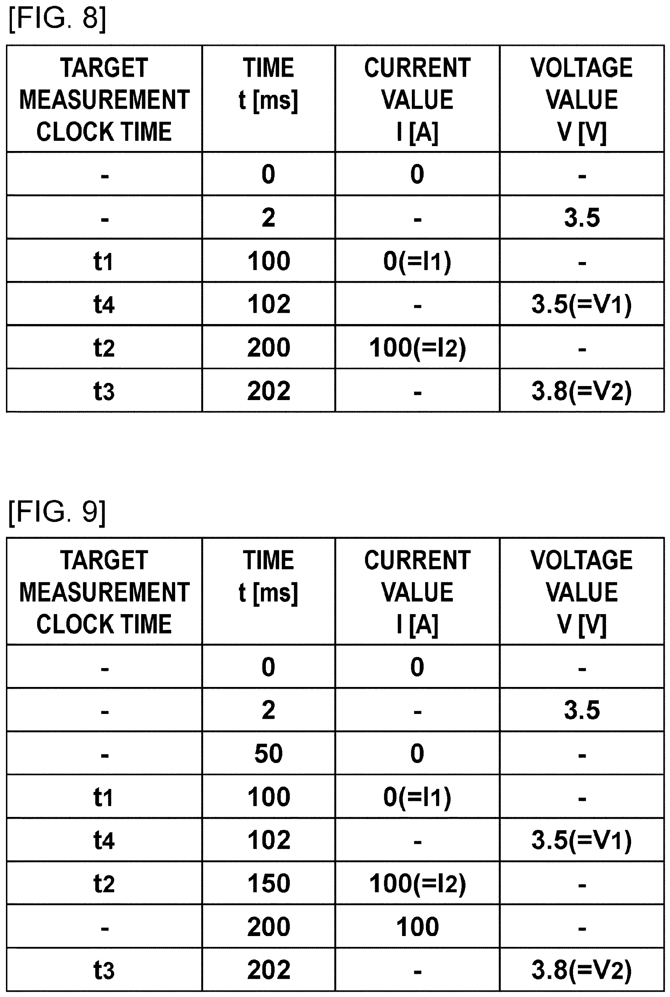

An example of an operation of the battery controller 101 of the present embodiment will be described with reference to FIG. 8. FIG. 8 is a table for depicting the target measurement clock time, a time from a predetermined clock time to each target measurement clock time, and actual measurement values (current values and voltage values). It should be noted that the figures are only examples.

As depicted in FIG. 8, the predetermined time Δtn that is the measurement cycle of each of the current value I and the voltage value V is 100 [ms]. The target measurement clock time of the voltage value V is set to a clock time that is the predetermined time Δtm = 2 [ms] later, which predetermined time is the deviation time from the target measurement clock time of the current value I. That is, the deviation of the measurement timing of the voltage value from the measurement timing of the current value is fixed. It should be noted that the battery controller 101 does not set the target measurement clock time itself. The battery controller 101 sets the predetermined time Δtn and the predetermined time Δtm that is the deviation time of the measurement timing of the voltage value V from the measurement timing of the current value I. The target measurement clock time is decided by setting the predetermined time Δtn and the predetermined time Δtm of the measurement timing.

When the current flowing through the battery 300 changes from 0 [A] to 100 [A], the battery controller 101 selects, as the first current value I1, 0 [A] measured at the first clock time t1 which is immediately before the current change, as the target measurement clock time. In addition, the battery controller 101 selects, as the first voltage value V1, 3.5 [V] measured at the fourth clock time t4 as the target measurement clock time, which is the predetermined time Δtm = 2 [ms] later than the first clock time t1. The battery controller 101 selects, as the second current value I2, 100 [A] measured at the second clock time t2, which is immediately after the current change, as the target measurement clock time. Further, the battery controller 101 selects, as the second voltage value V2, 3.8 [V] measured at the third clock time t3 as the target measurement clock time, which is the predetermined time Δtm later than the second clock time t2. The battery controller 101 computes the internal resistance value R on the basis of the selected first current value I1, second current value I2, first voltage value V1, and second voltage value V2.

In the present embodiment, the target measurement clock time of the current value I and the target measurement clock time of the voltage value V are intentionally deviated from each other by the predetermined time Δtm. Accordingly, the actual measurement timing of the voltage value V is always later than the actual measurement timing of the current value I. The actual measurement timing can be confirmed at the time of product shipment and maintenance work.

For example, a maintenance worker connects a maintenance device to the battery 300 during maintenance. The maintenance device is a device capable of controlling a current flowing through the battery 300 and measuring the voltage value V and the current value I of the battery 300. The maintenance worker changes the current flowing through the battery 300 in a predetermined current waveform by using the maintenance device. The maintenance device changes the charging current of the battery 300 in a charging waveform of, for example, 0 [A] for 100 seconds, 100 [A] for 1 second, 0 [A] for 100 seconds, 100 [A] for 1 second, and the like.

The maintenance device aggregates the voltage value (corresponding to the second voltage value) measured after the current change. The maintenance device back-calculates the clock time (voltage measurement clock time) at which the voltage value was actually measured on the basis of the aggregated voltage value and characteristic data of the change in the voltage value after the current change. The maintenance device computes voltage measurement clock times for all the aggregated voltage values after the current change. A storage device of the maintenance device stores a current change clock time and a voltage measurement clock time. Accordingly, variations in the voltage measurement clock time at which the current of the battery 300 has changed are measured a plurality of times.

The maintenance device causes a display device to display data about the current change clock time and the voltage measurement clock time stored in the storage device. The maintenance worker confirms the current change clock time and the voltage measurement clock time displayed on the display device. If the voltage measurement clock time closest to the current change clock time is later than the current change clock time in each of all the current change clock times, it can be confirmed that the computation function of the present embodiment is properly working.

(Working effect of embodiment)

According to the present embodiment, the following working effects are achieved.

As depicted in FIG. 3, the battery control device 100 includes the battery controller 101 as a computing device that computes the internal resistance value R of the battery 300. As depicted in FIG. 6 and FIG. 7, the battery controller 101 computes the current differential value $\Delta I$ on the basis of the first current value I1 and the second current value I2 ($\Delta I = I2 - I1$). The first current value I1 is a value measured at the first clock time t1 serving as the target measurement clock time. The second current value I2 is a value measured at the second clock time t2 serving as the target measurement clock time at which the predetermined time $\Delta tn$ has elapsed from the first clock time t1. The battery controller 101 computes the voltage differential value $\Delta V$ on the basis of the first voltage value V1 and the second voltage value V2 ($\Delta V = V2 - V1$). The first voltage value V1 is a value measured at a predetermined clock time (the fourth clock time t4 in the present embodiment) serving as the target measurement clock time that is later than the first clock time t1. The second voltage value V2 is a value measured at the third clock time t3 serving as the target measurement clock time that is later than the predetermined clock time (the fourth clock time t4 in the present embodiment) and at which the predetermined time $\Delta tm$ has elapsed from the second clock time t2. The battery controller 101 computes the internal resistance value R of the battery 300 on the basis of the current differential value $\Delta I$ and the voltage differential value $\Delta V$ ($R = \Delta V/\Delta I$). According to this configuration, in the case where the current changes during the time between the first clock time t1 and the second clock time t2, the second voltage value V2 used for computing the internal resistance value R can be prevented from being measured before the current change. Therefore, in the present embodiment, the reliability of the computed internal resistance value R can be improved. As a result, the battery 300 can maximize the battery performance until, for example, the end of life (EOL) of the battery 300.

The battery controller 101 measures the first voltage value V1 at the fourth clock time t4 serving as the target measurement clock time that is later than the first clock time t1 and earlier than the second clock time t2. According to this configuration, the first voltage value V1 before the current change can be properly measured.

The time $\Delta tm$ from the first clock time t1 to the fourth clock time t4 is equal to the time $\Delta tm$ from the second clock time t2 to the third clock time t3. That is, the measurement cycle of the current value I and the measurement cycle of the voltage value V by the battery controller 101 are equal to each other. In this manner, in a configuration in which the target measurement clock time of the current value I and the target measurement clock time of the voltage value V are always deviated from each other, the control design becomes easy and simple. In addition, since the processing of the battery controller 101 is simplified, the usage amount of the memory can be reduced.

The predetermined time $\Delta tm$ is larger than half ($= n$) of the deviation width $\Delta N$ [ms] of the measurement clock time of the second voltage value V2 from the measurement clock time of the second current value I2. According to this configuration, the voltage differential value $\Delta V$ used for computing the internal resistance value R is always computed on the basis of the second voltage value V2 measured after the current change and the first voltage value V1 measured before the current change. As a result, a highly reliable internal resistance value R can be obtained.

The battery control device 100 includes the voltage sensor 103 for measuring the voltage of the battery 300 and the current sensor 102 for measuring the current of the battery 300. According to this configuration, a highly reliable internal resistance value R can be obtained on the basis of the detection results of the voltage sensor 103 and the current sensor 102 provided in the battery control device 100.

As depicted in FIG. 1, the vehicle control device 10 includes the battery control device 100. The vehicle control device 10 controls the vehicle 1 having the battery 300 and electric equipment (the motor 600 and the like) operated by the electric power of the battery 300. According to this configuration, since the reliability of the internal resistance value R used for computation of the vehicle control device 10 is improved, the vehicle control device 10 can more properly control the electric equipment (the motor 600 and the like).

As depicted in FIG. 1, the vehicle 1 has the internal combustion engine (the engine 700) for travelling driving the vehicle 1. Since the reliability of the internal resistance value R used for various computations in the vehicle control device 10 is improved, the motor 600 and the engine 700 can be more properly controlled by the vehicle control device 10 when the vehicle is travelling.

The following modified examples are also within the scope of the present invention, and it is possible to combine configurations to be depicted in the modified examples with the configurations described in the above-described embodiment, or to combine configurations to be described in the following different modified examples with each other.

(Modified example 1)

In the above-described embodiment, an example in which the predetermined time that is the measurement cycle of the current value I and the predetermined time that is the measurement cycle of the voltage value V are the same has been described, but the present invention is not limited thereto. The measurement cycle of the current value I may be different from the measurement cycle of the voltage value V. For example, as depicted in FIG. 9, the measurement cycle of the current value I may be 1/2 of the measurement cycle of the voltage value V.

(Modified example 2)

In the above-described embodiment, an example in which the measurement cycle of the voltage value V is constant has been described. However, it is also possible to change only the measurement timing of the voltage value measured after the current change of the battery 300. In this configuration, the battery controller 101 computes the voltage differential value $\Delta V$ on the basis of the first voltage value V1 and the second voltage value V2 of the battery 300 in the case where the current differential value $\Delta I$ of the battery 300 exceeds a predetermined value. The predetermined value is, for example, 100 times or more of the variation width of the current value I of the battery 300 in the case where the current value of the battery 300 is not intentionally changed. The 100 times is merely an example, and is defined on the basis of the variation width of the current value I of the battery 300, and the like. In the modified example 2, when there is no current change in the battery 300, the target measurement clock time of the current value I and the target measurement clock time of the voltage value V are allowed to coincide with each other. The battery controller 101 monitors the change in the current and delays the target measurement clock time of the voltage value by the predetermined time in the case where it is determined that the current has changed (in the case where it is determined that the current differential value $\Delta I$ has exceeded a predetermined value). That is, each of the target measurement clock times of the first current value I1 and the first voltage value V1 is the first clock time t1, and the target measurement clock time of the second voltage value V2 is set to a clock time that is a predetermined time later than the target measurement clock time of the second current value I2. Even in such a configuration, the reliability of the internal resistance value R can be improved.

(Modified example 3)

In the above-described embodiment, in the case where the battery 300 is an assembled battery having a plurality of single cells, an example of computing the internal resistance value of the assembled battery by using the voltage of the assembled battery has been described. However, the present invention may be applied to the computation of the internal resistance value of the single cells using the voltage of the single cells configuring the assembled battery.

Although the embodiment of the present invention has been described above, the above-described embodiment depicts only a part of an application example of the present invention, and it is not intended to limit the technical scope of the present invention to the specific configuration of the above-described embodiment. For example, the present invention is not limited to the case where it is applied to the battery control device 100 for controlling the battery 300 mounted in the vehicle 1 as depicted in FIG. 1. The present invention can be applied to a battery control device 100 for controlling a battery 300 as a power source for operating various industrial machines such as airplanes and machine tools.

The configuration of the embodiment of the present invention may also be specified as follows.

The battery control device 100 includes the computing device (battery controller 101) for computing the internal resistance value R of the battery 300. The computing device computes the current differential value $\Delta I$ on the basis of the first current value I1 measured at the first clock time t1 as the target measurement clock time and the second current value I2 measured at the second clock time t2 serving as the target measurement clock time at which the predetermined time $\Delta tn$ has elapsed from the first clock time t1. The computing device computes the voltage differential value $\Delta V$ on the basis of the first voltage value V1 measured at a predetermined clock time serving as the target measurement clock time that is later than the first clock time t1 and earlier than the second clock time t2 and the second voltage value V2 measured at the third clock time t3 serving as the target measurement clock time at which the predetermined time $\Delta tm$ has elapsed from the second clock time t2. The computing device computes the internal resistance value R of the battery 300 on the basis of the current differential value $\Delta I$ and the voltage differential value $\Delta V$. According to this configuration, it is possible to suppress a large difference in the measurement point of time between the current and the voltage, so that the state of the target battery 300 can be computed with high accuracy.

The battery control device 100 has the computing section (battery controller 101) to which the voltage value V of the battery 300 and the current value I of the battery 300 are input to compute the internal resistance value R of the battery 300. The computing section computes the current differential value $\Delta I$ on the basis of the second current value I2 measured and input thereto at the second clock time t2 at which the predetermined time $\Delta tn$ has elapsed from the predetermined first clock time t1 and the first current value I1 measured and input thereto at the first clock time t1 ($\Delta I = I2 - I1$). The computing section computes the voltage differential value $\Delta V$ on the basis of the predetermined second voltage value $\Delta 2$ measured and input thereto during a period from the second clock time t2 to the third clock time t3 at which a predetermined time has elapsed from the second clock time t2 and the first voltage value V1 measured and input thereto at the first clock time t1 ($\Delta V = V2 - V1$). The computing section computes the internal resistance value R of the battery 300 on the basis of the voltage differential value $\Delta V$ and the current differential value $\Delta I$.

The battery control device 100 has the computing section to which the voltage value of the battery 300 measured at a predetermined clock time and the current value of the battery 300 measured at the predetermined clock time are input to compute the internal resistance value of the battery 300. The predetermined clock time includes the first clock time t1 < the second clock time t2 < the third clock time t3. The computing section computes the current differential value $\Delta I$ on the basis of the second current value I2 measured at the second clock time t2 by a current measurement unit (current sensor 102) and the first current value I1 measured at the first clock time t1 by the current measurement unit (current sensor 102) ($\Delta I = I2 - I1$). The computing section computes the voltage differential value $\Delta V$ on the basis of the predetermined second voltage value V2 measured between the second clock time t2 and the third clock time t3 by a voltage measurement unit (voltage sensor 103) and the first voltage value V1 measured at the first clock time t1 by the voltage measurement unit (voltage sensor 103) ($\Delta V = V2 - V1$). The computing section computes the internal resistance value R of the battery 300 on the basis of the voltage differential value $\Delta V$ and the current differential value $\Delta I$ ($I2 - I1$).

Description of Reference Characters

1: vehicle
10: vehicle control device
20: battery pack
100: battery control device
101: battery controller (computing device, computing section)
101a: processing device
101b: storage device
102: current sensor
103: voltage sensor
110: time measuring section
111: battery information acquisition section
112: internal resistance computing section
113: SOC computing section
114: allowable current computing section
115: SOHR computing section
200: vehicle equipment control device
300: battery
400: relay
500: electric power converter
600: motor (electric equipment)
700: engine (internal combustion engine)
DCR: DC resistance value
I: current value
I1: first current value
I2: second current value
R: internal resistance value
Ri: reference resistance value
SOC: charge rate
SOF: discharge performance
SOHR: resistance increase rate
V: voltage value
V1: first voltage value

V2: second voltage value
n: maximum deviation amount
t1: first clock time
t2: second clock time
t3: third clock time
t4: fourth clock time
$\Delta$I: current differential value
$\Delta$I0: threshold value
$\Delta$N: deviation width
$\Delta$V: voltage differential value
$\Delta$tm: predetermined time
$\Delta$tn: predetermined time

**Claims**

1. A battery control device comprising: a computing device that computes an internal resistance value of a battery, wherein
   the computing device

   computes a current differential value on a basis of a first current value measured at a first clock time serving as a target measurement clock time and a second current value measured at a second clock time serving as a target measurement clock time at which a predetermined time has elapsed from the first clock time,
   computes a voltage differential value on a basis of a first voltage value measured at a predetermined clock time serving as a target measurement clock time that is later than the first clock time and a second voltage value measured at a third clock time serving as a target measurement clock time that is later than the predetermined clock time and at which a predetermined time has elapsed from the second clock time, and
   computes the internal resistance value of the battery on a basis of the current differential value and the voltage differential value.

2. The battery control device according to claim 1, wherein
   the computing device measures the first voltage value at a fourth clock time serving as a target measurement clock time that is later than the first clock time and earlier than the second clock time.

3. The battery control device according to claim 2, wherein
   a time from the first clock time to the fourth clock time is equal to a time from the second clock time to the third clock time.

4. The battery control device according to claim 1, wherein
   the computing device computes the voltage differential value on the basis of the first voltage value and the second voltage value when the current differential value exceeds a predetermined value.

5. The battery control device according to claim 1, further comprising:

   a voltage sensor that measures a voltage value of the battery; and
   a current sensor that measures a current value of the battery.

6. A vehicle control device comprising: the battery control device according to claim 1, wherein
   the vehicle control device controls a vehicle having the battery and electric equipment operated by electric power of the battery.

7. The vehicle control device according to claim 6, wherein
   the vehicle has an internal combustion engine for travelling driving the vehicle.

[FIG. 1]

[FIG. 2]

[FIG. 3]

BATTERY CONTROL DEVICE · 100

CURRENT SENSOR · 102

VOLTAGE SENSOR · 103

BATTERY CONTROLLER · 101

BATTERY INFORMATION ACQUISITION SECTION · 111

TIME MEASURING SECTION · 110

SOC COMPUTING SECTION · 113

INTERNAL RESISTANCE COMPUTING SECTION · 112

ALLOWABLE CURRENT COMPUTING SECTION · 114

SOHR COMPUTING SECTION · 115

VEHICLE EQUIPMENT CONTROL DEVICE · 200

[FIG. 4]

[FIG. 5]

[FIG. 6]

[FIG. 7]

```
        ┌─────────────┐
        │    START    │
        └─────────────┘
               │
               ▼                            S110
   ┌──────────────────────────────┐
   │    MEASURE CURRENT VALUE      │
   └──────────────────────────────┘
               │
               ▼                            S120
   ┌──────────────────────────────┐
   │    MEASURE VOLTAGE VALUE      │
   └──────────────────────────────┘
               │
               ▼                            S130
   ┌──────────────────────────────┐
   │ COMPUTE CURRENT DIFFERENTIAL  │
   │            VALUE              │
   └──────────────────────────────┘
               │
               ▼                            S140
           ╱───────────╲                  No
          ╱ HAS CURRENT  ╲─────────────────┐
          ╲ VALUE CHANGED?╱                │
           ╲───────────╱                   │
               │ Yes                       │
               ▼                  S150      │
   ┌──────────────────────────────┐        │
   │ COMPUTE VOLTAGE DIFFERENTIAL  │        │
   │            VALUE              │        │
   └──────────────────────────────┘        │
               │                            │
               ▼                  S160      │
   ┌──────────────────────────────┐        │
   │ COMPUTE INTERNAL RESISTANCE   │        │
   │            VALUE              │        │
   └──────────────────────────────┘        │
               │                            │
               ▼                  S170      │
   ┌──────────────────────────────┐        │
   │ COMPUTE RESISTANCE INCREASE   │        │
   │  RATE AND ALLOWABLE CURRENT   │        │
   └──────────────────────────────┘        │
               │                            │
               ▼                  S180      │
   ┌──────────────────────────────┐        │
   │   OUTPUT COMPUTATION RESULT   │        │
   └──────────────────────────────┘        │
               │                            │
               ▼                            │
        ┌─────────────┐                     │
        │     END     │                     │
        └─────────────┘                     │
```

[FIG. 8]

| TARGET MEASUREMENT CLOCK TIME | TIME t [ms] | CURRENT VALUE I [A] | VOLTAGE VALUE V [V] |
|---|---|---|---|
| - | 0 | 0 | - |
| - | 2 | - | 3.5 |
| t1 | 100 | 0(=I1) | - |
| t4 | 102 | - | 3.5(=V1) |
| t2 | 200 | 100(=I2) | - |
| t3 | 202 | - | 3.8(=V2) |

[FIG. 9]

| TARGET MEASUREMENT CLOCK TIME | TIME t [ms] | CURRENT VALUE I [A] | VOLTAGE VALUE V [V] |
|---|---|---|---|
| - | 0 | 0 | - |
| - | 2 | - | 3.5 |
| - | 50 | 0 | - |
| t1 | 100 | 0(=I1) | - |
| t4 | 102 | - | 3.5(=V1) |
| t2 | 150 | 100(=I2) | - |
| - | 200 | 100 | - |
| t3 | 202 | - | 3.8(=V2) |

## INTERNATIONAL SEARCH REPORT

| International application No. |
| --- |
| **PCT/JP2024/014850** |

| A. | CLASSIFICATION OF SUBJECT MATTER |
| --- | --- |

*G01R 31/389*(2019.01)i; *G01R 27/08*(2006.01)i; *G01R 31/382*(2019.01)i; *G01R 31/385*(2019.01)i; *G01R 31/392*(2019.01)i; *H01M 10/48*(2006.01)i; *H02J 7/00*(2006.01)i
FI:   G01R31/389; G01R27/08; G01R31/382; G01R31/385; G01R31/392; H01M10/48 P; H02J7/00 P; H02J7/00 Y

According to International Patent Classification (IPC) or to both national classification and IPC

| B. | FIELDS SEARCHED |
| --- | --- |

Minimum documentation searched (classification system followed by classification symbols)

G01R31/36; G01R27/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2021-512451 A (LG CHEM, LTD.) 13 May 2021 (2021-05-13) paragraphs [0001], [0004]-[0013], [0027]-[0068], fig. 1-11 | 1-5 |
| Y | | 6-7 |
| Y | JP 2020-177813 A (TOYOTA JIDOSHA KABUSHIKI KAISHA) 29 October 2020 (2020-10-29) paragraphs [0001]-[0002], [0014], fig. 1 | 6-7 |
| A | JP 2019-203745 A (TOYOTA JIDOSHA KABUSHIKI KAISHA) 28 November 2019 (2019-11-28) entire text, all drawings | 1-7 |
| A | KR 10-2016-0067551 A (HYUNDAI MOBIS CO., LTD.) 14 June 2016 (2016-06-14) entire text, all drawings | 1-7 |

☑ Further documents are listed in the continuation of Box C.       ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **17 May 2024** | **04 June 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| --- |
| **PCT/JP2024/014850** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2013-221790 A (KABUSHIKI KAISHA TOYOTA JIDOSHOKKI) 28 October 2013 (2013-10-28)<br>entire text, all drawings | 1-7 |
| A | JP 2008-32683 A (HIOKI ELECTRIC WORKS) 14 February 2008 (2008-02-14)<br>entire text, all drawings | 1-7 |
| A | JP 2018-96803 A (SUMITOMO ELECTRIC INDUSTRIES, LTD.) 21 June 2018 (2018-06-21)<br>entire text, all drawings | 1-7 |

Form PCT/ISA/210 (second sheet) (July 2022)

INTERNATIONAL SEARCH REPORT
Information on patent family members

International application No.

**PCT/JP2024/014850**

| Patent document cited in search report | | | Publication date (day/month/year) | Patent family member(s) | | | Publication date (day/month/year) |
|---|---|---|---|---|---|---|---|
| JP | 2021-512451 | A | 13 May 2021 | US fig. 1-11, paragraphs [0001]-[0013], [0024]-[0050] WO EP CN KR | 2020/0166579 2020/106043 3761048 111989581 10-2021-0082124 | A1 A1 A1 A A | |
| JP | 2020-177813 | A | 29 October 2020 | (Family: none) | | | |
| JP | 2019-203745 | A | 28 November 2019 | (Family: none) | | | |
| KR | 10-2016-0067551 | A | 14 June 2016 | (Family: none) | | | |
| JP | 2013-221790 | A | 28 October 2013 | (Family: none) | | | |
| JP | 2008-32683 | A | 14 February 2008 | (Family: none) | | | |
| JP | 2018-96803 | A | 21 June 2018 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021092403 A